# EUROPEAN PATENT APPLICATION

(11) **EP 2 455 969 A2**
(43) Date of publication of application: **23.05.2012**
(21) Application number: 11009070.1
(22) Date of filing: 15.11.2011
(51) Int. Cl.: H01L 25/075, H01L 33/50, F21K 99/00

(54) **Light emitting device**

(30) Priority: 17.11.2010 JP 2010257069
(71) Applicant: Panasonic Corporation, Osaka 571-8501 (JP)
(72) Inventor: Nishioka, Kouji, Osaka (JP); Takei, Naoko, Osaka (JP)
(74) Representative: Samson & Partner

(57) **Abstract**

A light emitting device includes a first solid light-emitting element including a first light source for emitting blue light and a first fluorescent body excited by the blue light from the first light source to convert the blue light to light having a peak at wavelength between 630 nm and 680 nm and a second solid light-emitting element including a second light source for emitting blue light and a second fluorescent body excited by the blue light from the second light source to convert the blue light to light having a peak at wavelength between 500 nm and 550 nm.

## Description

### Field of the Invention

The present invention relates to a light emitting device that emits light by fluorescent bodies excited by the light from solid light-emitting elements including such as LEDs or the like.

### Background of the Invention

As the light emitting device mentioned above, there is known a light emitting device which emits white light by using a pair of blue LEDs with different peak light-emitting wavelengths from each other, a yellow fluorescent body for emitting light by absorbing blue light from one of the blue LEDs, and green and red fluorescent bodies for emitting light by absorbing blue light from the other blue LED (see, e.g., Japanese Patent Application Publication No. 2008-34188). The light emitting device is designed to combine two kinds of white light to generate light similar to the natural light, thereby removing color unevenness.

There is also known a light emitting device including a light-emitting element and a fluorescent conversion filter having a fluorescent conversion film that converts light from a wavelength region between near ultraviolet and green to light in the red region (see, e.g., Japanese Patent Application Publication No. 2000-91071). The light emitting devices described above can output light with a high color rendering property as compared with a conventional light emitting device in which white light is outputted by combining lights from a blue LED and a yellow fluorescent body.

However, the lights irradiated by the light emitting devices described above contain a lot of yellow light components close to the wavelength range of a red light component. Foods (especially, meat) irradiated by illumination light containing a lot of yellow light components do not look fresh and fail to provide a great enough color rendering effect which makes the food look vivid and fine.

### Summary of the Invention

In view of the above, the present invention provides a light emitting device capable of reducing yellow light components contained in irradiation light, highlighting visual performance of a red color and consequently displaying food so as to look vivid and fine.

In accordance with a first aspect of the present invention, there is provided a light emitting device, including: a first solid light-emitting element including a first light source for emitting blue light and a first fluorescent body excited by the blue light from the first light source to convert the blue light to light having a peak at wavelength between 630 nm and 680 nm; and a second solid light-emitting element including a second light source for emitting blue light and a second fluorescent body excited by the blue light from the second light source to convert the blue light to light having a peak at wavelength between 500 nm and 550 nm.

Further, the first solid light-emitting element may be arranged in a position relatively close to a central area.

Further, each of the first and the second light source may be a light emitting diode for emitting the blue light.

Further, each of the first and the second light source may be an organic light-emitting diode for emitting the blue light.

In accordance with a second aspect of the present invention, there is provided an illumination system, including: a first light emitting device including a first solid light-emitting element having a first light source for emitting blue light and a first fluorescent body excited by the blue light from the first light source to convert the blue light to light having a peak at wavelength between 630 nm and 680 nm; and a second light emitting device including a second solid light-emitting element having a second light source for emitting blue light and a second fluorescent body excited by the blue light from the second light source to convert the blue light to light having a peak at wavelength between 500 nm and 550 nm.

In accordance with a third aspect of the present invention, there is provided a light irradiation method, including: providing a first fluorescent body for converting blue light emitted from a first light source to light having a peak at wavelength between 630 nm and 680 nm; providing a second fluorescent body for converting blue light emitted from a second light source to light having a peak at wavelength between 500 nm and 550 nm; and converting the lights from the first and the second fluorescent body to light having a maximum peak at wavelength between 630 nm and 680 nm.

With the light emitting device in accordance with the present invention, it is possible to have irradiation light, which is a combination of light emitted from a solid light-emitting element including a first fluorescent body for converting the emitted light to light having a peak at wavelength between 630 nm and 680 nm and light emitted from a solid light-emitting element including a second fluorescent body for converting the emitted light to light having a peak at wavelength between 500 nm and 550 nm. As a result, the light emitting device is capable of relatively reducing yellow light components contained in irradiation light, highlighting visual performance of a red color and consequently displaying food (especially, meat) so as to look vivid and fine.

### Brief Description of the Drawings

The objects and features of the present invention will become apparent from the following description of embodiments, given in conjunction with the accompanying drawings, in which:
Fig. 1 is a configuration view showing a light emitting device in accordance with a first embodiment of the present invention;
Fig. 2 is a section view of the light emitting device taken along line II-II in Fig. 1;
Fig. 3A is a view for explaining a spectral distribution of the light irradiated from first and second fluorescent bodies and the light re-absorption of the first fluorescent body, and Fig. 3B is a view depicting a spectral distribution of the combination of the lights irradiated from the first and second fluorescent bodies;
Fig. 4 is a configuration view showing a modification of the light emitting device shown in Fig. 1;
Fig. 5 is a configuration view showing an illumination system in accordance with a second embodiment of the present invention;
Fig. 6 is a view representing the spectral reflection characteristic from meat;
Fig. 7 is a view representing the spectral distribution of irradiation light in Example 1;
Fig. 8 is a view representing the spectral distribution of irradiation light in Example 2; and
Fig. 9 is a view representing the spectral distribution of irradiation light in a comparative example.

### Detailed Description of the Preferred Embodiments

Hereinafter, a light emitting device in accordance with a first embodiment of the present invention will be described with reference to accompanying drawings which form a part hereof.

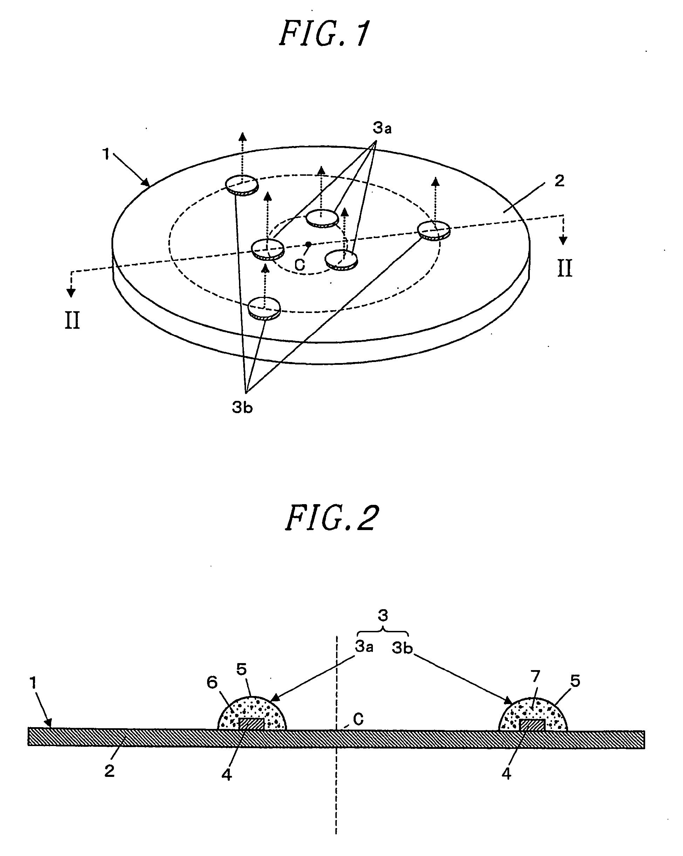

Referring to Figs. 1 and 2, the light emitting device 1 includes a mounting substrate 2 and a plurality of solid light-emitting elements 3, each of which has a light source for emitting blue light, mounted on the mounting substrate 2.

The solid light-emitting elements 3 include first solid light-emitting elements 3a and second solid light-emitting elements 3b. Each of the first solid light-emitting elements 3a includes a first fluorescent body 6 excited by the blue light to convert the blue light to light having a peak at wavelength between 630 nm and 680 nm. Each of the second solid light-emitting elements 3b includes a second fluorescent body 7 excited by the blue light to convert the blue light to light having a peak at wavelength between 500 nm and 550 nm. All or most of the first solid light-emitting elements 3a are arranged in positions relatively close to the center of the mounting substrate 2. In the present embodiment, the first and second solid light-emitting elements 3a and 3b are arranged at regular intervals on two different concentric circles about a center axis C of the mounting substrate 2, three on each circle. The first solid light-emitting elements 3a are arranged on one of the concentric circles having a smaller diameter. Alternatively, some of the first solid light-emitting elements 3a may be arranged on the concentric circle on which the second solid light-emitting elements 3b are arranged. A PCB (printed circuit board) substrate or a ceramic substrate may be used as the mounting substrate 2. The shape of the mounting substrate 2 is not limited to the circular one shown in Fig. 1 but may be, e.g., polygonal. Further, the number and the arrangement of the solid light-emitting elements 3 are not limited to the above. As an alternative example, the solid light-emitting elements 3 may be arranged on the mounting substrate 2 in a parallel line pattern or a crisscross pattern. The current supply and amounts of lights emitted from the first and second solid light-emitting elements 3a and 3b are controlled by a power supply drive circuit (not shown) through a wiring pattern on the mounting substrate 2.

Each of the first solid light-emitting elements 3a includes a light emitting diode (LED) 4 as the light source for emitting blue light, a transparent member 5 for encapsulating the LED 4 and a first fluorescent body 6 for converting the wavelength of the blue light emitted from the LED 4. The first fluorescent body 6 is dispersed and held within the transparent member 5. The first fluorescent body 6 partially absorbs the blue light having a peak at wavelength between 430 nm and 470 nm emitted from the LED 4 and irradiates wavelength-converted red light having a peak at wavelength between 630 nm and 680 nm together with the remaining blue light whose wavelength is not converted.

Similar to the first solid light-emitting elements 3a, each of the second solid light-emitting elements 3b includes a light emitting diode (LED) 4 as the light source for emitting blue light, a transparent member 5 for encapsulating the LED 4 and a second fluorescent body 7 for converting the wavelength of the blue light emitted from the LED 4. The second fluorescent body 7 is dispersed and held within the transparent member 5. The second fluorescent body 7 absorbs the blue light having a peak at wavelength between 430 nm and 470 nm emitted from the LED 4 and coverts the blue light to green light having a peak at wavelength between 500 nm and 550 nm which is longer than the wavelength of the blue light.

The LED 4 emits blue light having a peak at wavelength, e.g., between 430 nm and 470 nm. The LED 4 may be in the form of a semiconductor chip. Instead of the LED, an organic light-emitting diode (OLED) emitting blue light may be used in the solid light-emitting element.

The transparent member 5 is a binder for holding the fluorescent body. The binder is formed of a transparent material such as a silicone resin or an epoxy resin. The first fluorescent body 6 is dispersed and held within the binder. The transparent member 5 covers the chip-like LED 4 mounted on the mounting substrate 2. The transparent member 5 is not limited to the resin material noted above. The shape of the transparent member 5 covering the LED 4 is not particularly limited and may be, e.g., a cannonball shape or a hemispherical shape so that the transparent member 5 can serve as a light-collecting lens. If necessary, a diffuser (particles made of an inorganic material such as aluminum oxide or silica, or an organic material such as fluorine-based resin) or a pigment may be dispersed in the binder. Alternatively, a molded object may be formed of a binder having the first fluorescent body 6 dispersed therein and the LED 4 may be covered with the molded object.

The operation of the light emitting device 1 configured as above will now be described. Each of the first solid light-emitting elements 3a outputs mixed light of a blue light component and a red light component having a peak at wavelength between 630 nm and 680 nm, the blue light component being emitted from the LED 4 and transmitted through the transparent member 5 without being absorbed by the first fluorescent body 6 and the red light component being obtained by wavelength conversion of the blue light in the first fluorescent body 6. Similarly, each of the second solid light-emitting elements 3b outputs mixed light of a blue light component and a green light component having a peak at wavelength between 500 nm and 550 nm, the blue light component being emitted from the LED 4 and transmitted through the transparent member 5 without being absorbed by the second fluorescent body 7 and the green light component being obtained by wavelength conversion of the blue light in the second fluorescent body 7. As a result, the light emitting device 1 irradiates an irradiation target with white irradiation light containing red light, green light and a part of the blue light emitted from the LEDs 4 in the first and second solid light-emitting elements.

Meanwhile, in case of a light emitting device in which the first and second fluorescent bodies are arranged in combination within a molded object and are simultaneously excited by light emitted from a blue LED, a part of green light irradiated from the second fluorescent body is re-absorbed by the first fluorescent body within the molded object (which corresponds to the comparative example set forth later).

This will be described in detail with reference to

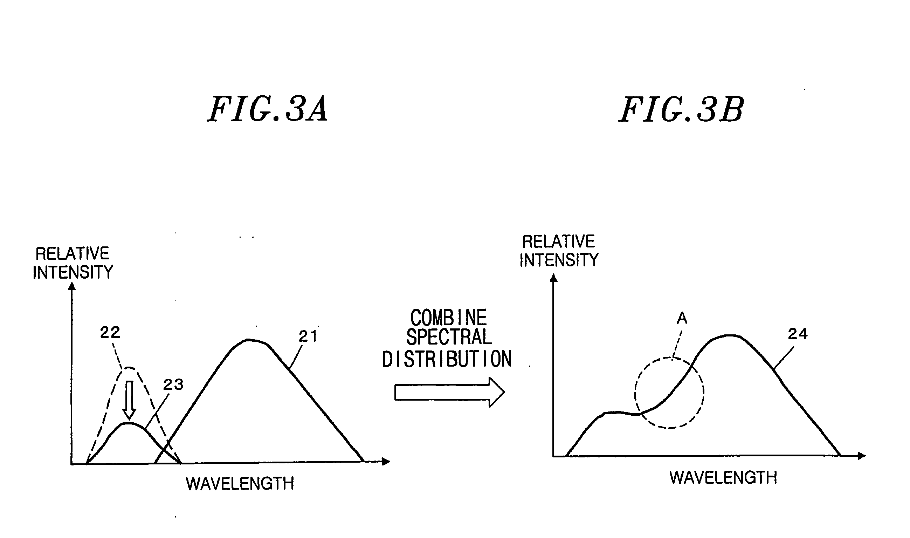

Figs. 3A and 3B. Referring to Fig. 3A, the curve designated by reference numeral 21 indicates a spectral distribution of the light irradiated from the first fluorescent body. The light has a peak at wavelength in the red light region.

The curve designated by reference numeral 22 indicates a spectral distribution of the light irradiated from the second fluorescent body when no re-absorption occurs. The light has a peak at wavelength in the green light region. The level of the spectral distribution 22 is reduced to the level of a spectral distribution 23 due to re-absorption. At this time, the green light re-absorbed by the first fluorescent body is converted to light having a wavelength longer than the wavelength of the green light. Consequently, as depicted in Fig. 3B, the irradiation light has a composite spectral distribution 24 that is the sum of the spectral distribution 21 of the red light and the reduced spectral distribution 23 of the green light. This generates irradiation light having a relatively high yellow light component as indicated by circle A in Fig. 3B, eventually increasing the dullness of color attributable to the yellow light component.

In the present embodiment, however, the first (red) and second (green) fluorescent bodies 6 and 7 are respectively arranged in the different solid light-emitting elements 3a and 3b and are excited by the blue light emitted from the LEDs 4 of the respective solid light-emitting elements 3a and 3b. This eliminates the possibility that a part of the green light generated by the wavelength conversion in the second fluorescent body 7 is re-absorbed by the first fluorescent body 6.

Accordingly, it is possible to relatively suppress the yellow light component which makes food as an irradiation target look dull, thereby relatively making the red light component remarkable. As a result, it becomes possible to highlight the red color of food (especially, meat) as an irradiation target, thereby making the food look vivid. In addition, a natural light color can be realized by combining the blue, green and red light.

Moreover, in the present embodiment, a plurality of fluorescent bodies is not excited together by a single LED to simultaneously generate different kinds of lights having different colors. Instead, the fluorescent bodies are arranged in a one-to-one relationship with the LEDs. This makes it possible to individually generate lights having necessary colors and combine the lights thus generated, and to avoid generation and irradiation of lights having unnecessary colors, thereby increasing a color rendering effect.

Among the solid light-emitting elements 3, the first solid light-emitting elements 3a are arranged in positions relatively close to the center of the mounting substrate 2. This makes it easy to irradiate an irradiation target which is often arranged at the center of an irradiation surface during display of goods. Further, by employing the blue LEDs in the solid light-emitting elements, it is possible to save electric power. If an organic light-emitting diode that emits blue light is used, the surface light emission thereof makes it easy to broaden the irradiation region.

### (Modification)

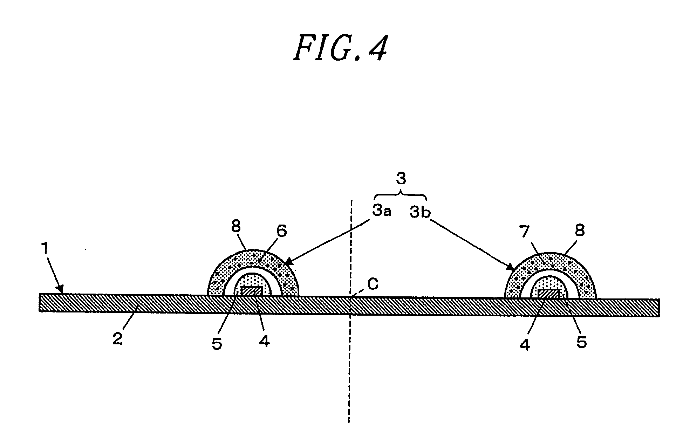

Fig. 4 shows a modification of the light emitting device shown in Fig. 1. In this modification, each of the first and second solid light-emitting elements 3a and 3b includes a cap-like molded object 8 further covering the LED 4 covered with the transparent member 5. Each of the first and second fluorescent bodies 6 and 7 is not arranged within the transparent member 5 but is dispersedly arranged within the molded object 8. Similar to the transparent member 5, the molded object 8 can be made of a transparent material. The transparent member 5 may be omitted by increasing the strength of the molded object 8 covering the LED 4 mounted on the mounting substrate 2. With this modification, when replacing the first and second fluorescent bodies 6 and 7, only the molded object 8 is replaced while the LED 4 is kept intact. This makes it possible to reuse the LED 4.

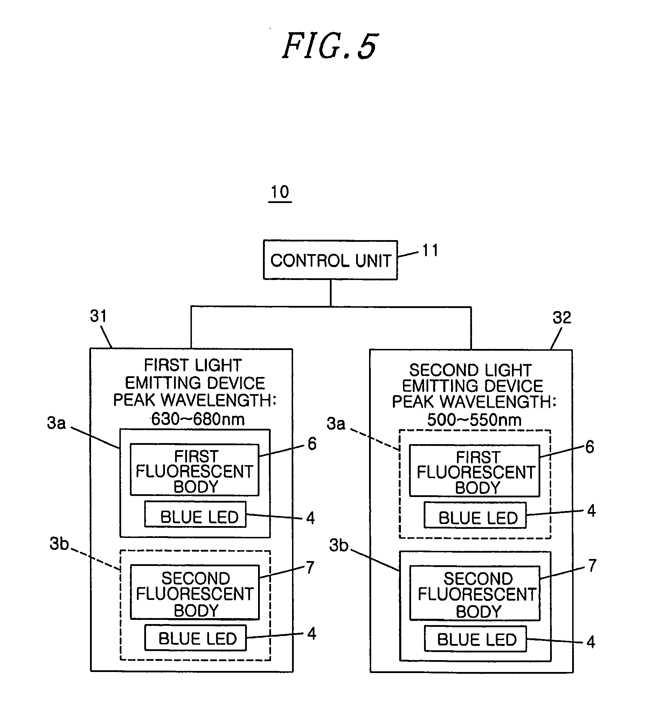

An illumination system in accordance with a second embodiment of the present invention will be described with reference to Fig. 5. The illumination system 10 of the present embodiment includes a plurality of light emitting devices, e.g., first and second light emitting devices 31 and 32, for irradiating an irradiation target with lights having different peak wavelengths and a control unit 11 for controlling light emission of the light emitting devices.

Each of the first and second light emitting devices 31 and 32 is arranged on a mounting substrate and includes first solid light-emitting elements 3a and 3b. The first solid light-emitting element 3a includes a blue LED 4 for emitting blue light and a first fluorescent body 6 excited by the blue light from the blue LED 4 to convert the blue light to a light having a peak at wavelength between 630 nm and 680 nm. The second solid light-emitting element 3b includes a blue LED 4 for emitting blue light and a second fluorescent body 7 excited by the blue light from the blue LED 4 to convert the blue light to a light having a peak at wavelength between 500 nm and 550 nm. The first light emitting device 31 is designed to emit an irradiation light having a maximum peak (maximum intensity) at wavelength between 630 nm and 680 nm in red light region. The second light emitting device 32 is designed to emit an irradiation light having a maximum peak at wavelength between 500 nm and 550 nm in green light region.

The control unit 11 controls light emission of the respective blue LEDs 4, thereby adjusting the light emission amounts from the first and second light emitting devices 31 and 32. This makes it possible to obtain the irradiation lights set forth above. The first and second light emitting devices 31 and 32 pre-set respective ratios between the amounts of the first and second fluorescent bodies 6 and 7 to have specified values. This makes it easy to obtain desired peak wavelength characteristics from the respective light emitting devices 31 and 32 when the light emission amounts thereof are adjusted by the control unit 11. In the present embodiment, one first solid light-emitting element 3a and one second solid light-emitting element 3b are arranged in each of the first and second light emitting devices 31 and 32. However, the present invention is not limited thereto. As an alternative example, two or more first solid light-emitting elements 3a may be arranged in the first light emitting device 31 and two or more second solid light-emitting elements 3b may be arranged in the second light emitting device 32. That is to say, it is only necessary that each of the first and second light emitting devices 31 and 32 be configured to emit the irradiation light having the maximum peak at wavelength range described above. Further, for example, the first light emitting device 31 may not include the second fluorescent body 7, and the second light emitting device 32 may not include the first fluorescent body 6.

With the illumination system 10 of the present embodiment, even if the irradiated food is replaced so that the spectrum reflectance thereof is changed, it is only necessary that the ratio of the light emission amounts of the first and second light emitting devices 31 and 32 be changed in keeping with the change of the spectrum reflectance. This makes it possible to enhance the display effect of an irradiation target. Further, the illumination system 10 may be a simplified system provided with no control unit.

Next, Examples 1 to 3 associated with the above-described embodiments and a comparative example will be described in comparison. Examples 1 and 2 have the same configuration as the light emitting device in accordance with the first embodiment and Example 3 has the same configuration as the illumination system in accordance with the second embodiment. In the comparative example, the first and second fluorescent bodies 6 and 7 are arranged together in the molded object covering the LED 4.

### <Light Irradiation Method>

Blue lights were converted by a first fluorescent body having a peak at wavelength in red light region and also by a second fluorescent body having a peak at wavelength in green light region such that the converted wavelength distribution has a maximum peak at wavelength in red light region. An irradiation target was irradiated with the irradiation light thus obtained. The peak of the light irradiated from the first fluorescent body was set at wavelength between 630 nm and 680 nm and the peak of the light irradiated from the second fluorescent body was set at wavelength between 500 nm and 550 nm, so that the spectral distribution of the irradiation light obtained from the fluorescent bodies can have a maximum peak at wavelength between 630 nm and 680 nm in red light region.

### <Evaluation of Irradiation Light>

Evaluation was conducted by using a metric chroma value (C*_{ab}) suitable for color evaluation as an evaluation index for determining whether or not the food irradiated with the light of the light emitting devices looks preferably fine. In an evaluation using a metric chroma value, a high metric chroma value represents a high chroma, which makes it possible to display the irradiation target in a desirable manner. After calculating the chromaticity coordinates of a CIEL*a*b* color space (an even color space indicated by a color metric system of CIE1976L*a*b*) from the spectral distribution of irradiation light and the spectrum reflectance of meat as an irradiation target, the metric chroma value is calculated from the values a* and b* by using an equation: C*_{ab} = (a*²+b*²) ^{1/2}, where a* and b* are sensory chromaticity indices in the CIEL*a*b* color space.

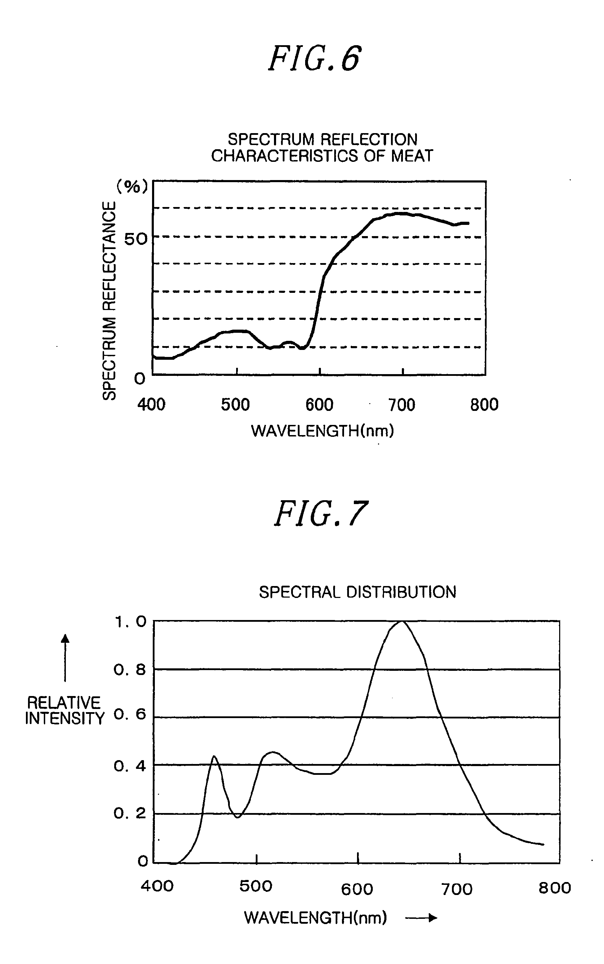

One example of the spectrum reflection characteristics of meat is represented in Fig. 6. In the graph represented in Fig. 6, the vertical axis signifies a spectrum reflectance (%) and the horizontal axis denotes a wavelength (nm). As can be seen from the spectrum reflection characteristics, the peak of the spectrum reflectance of meat exists in a wavelength range beyond 600 nm and the spectrum reflectance is sharply decreased in a wavelength range below 600 nm (e.g., in a yellow light range).

### (Example 1)

In the light emitting device of Example 1, among the LEDs for emitting blue light having a peak wavelength of 460 nm, each of the LEDs arranged close to the central region was covered with a molded object having the first fluorescent body dispersed therein and each of the remaining LEDs was covered with a molded object having the second fluorescent body dispersed therein. The first fluorescent body converted the blue light to red light having a peak at wavelength of 650 nm and the second fluorescent body converted the blue light to green light having a peak at wavelength of 520 m.

Fig. 7 represents the spectral distribution of the irradiation light in Example 1. The relative intensity of the red light having a peak wavelength of 650 nm is indicated by normalizing the same to have a maximum value equal to 1. It can be noted that the yellow light component in a range from about 560 nm to 600 nm in wavelength is smaller in relative intensity compared to the green light having the peak at wavelength of 520 nm. The metric chroma value was equal to 46 when meat was irradiated with such irradiation light.

### (Example 2)

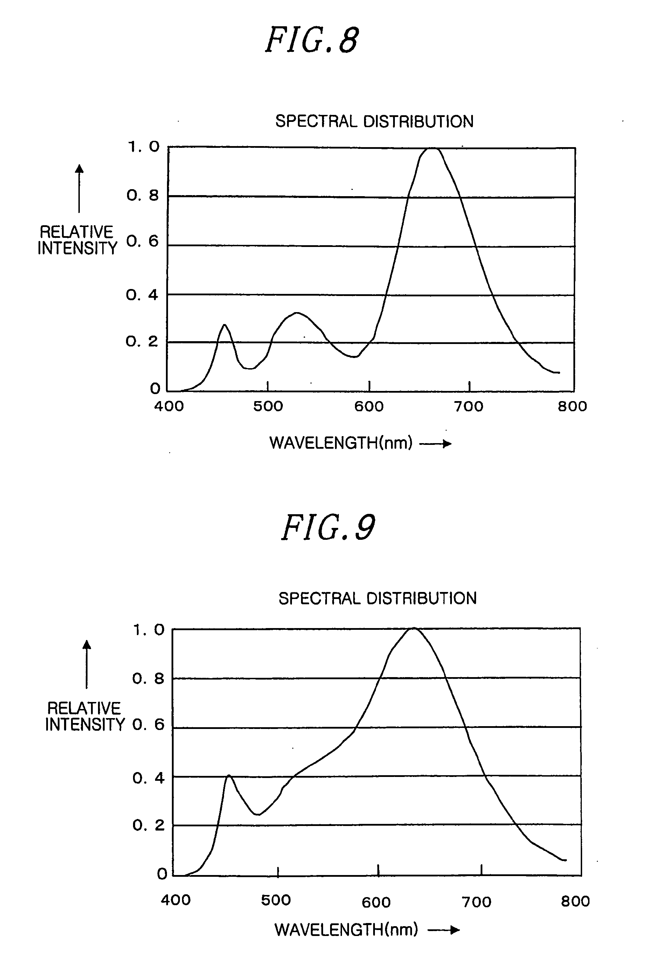

In the light emitting device of Example 2, the first fluorescent body was configured to emit red light having a peak at wavelength of 660 nm and the second fluorescent body was configured to emit green light having a peak at wavelength of 530 nm with a reduced Full width at half maximum (FWHM). Other conditions remained the same as in Example 1. Fig. 8 represents the spectral distribution of the irradiation light in Example 2. It can be noted that the yellow light component in a range from about 560 nm to 600 nm in wavelength is smaller in relative intensity than the green light having the peak at wavelength of 530 nm and further that relative intensities of the blue light, the green light and the yellow light are all greatly smaller than that of the red light. In this case, the metric chroma value was equal to 53 when meat was irradiated with such irradiation light.

The evaluation result in Example 2 indicates that the FWHM of a peak of the irradiation light emitted by the fluorescent bodies is required to preferably be as small as possible in order to make the meat as an irradiation target look fine and to produce a natural light color while maintaining a color rendering property. In particular, if the FWHM of the green light component is made smaller, the irradiation light gets closer to white light, which makes the color of an object around the meat look natural. For example, if the red light is strong or if only the red light exists, a white dish containing meat looks red. By adding the green light, the white dish looks white, thereby making the red color of the meat on the white dish look conspicuous. As a result, the chroma grows higher, which makes it possible to increase the metric chroma value. The FWHM of the red light or the FWHMs of both the red light and the green light may be set smaller to make the red light remarkable. At any rate, it is preferred that the FWHM be set as small as possible.

### (Example 3)

In the first and second light emitting devices of Example 3, the irradiation lights had a maximum peak at wavelength of 650 nm in red light region and a maximum peak at wavelength of 520 nm in green light region, respectively. The peak becoming greatest in the spectral distribution of the combined irradiation light was set at wavelength of 650 nm. The metric chroma value was equal to 46 when meat was irradiated with the irradiation light of Example 3.

### (Comparative Example)

In the light emitting device of the comparative example, each of the LEDs for emitting blue light having a peak at wavelength of 460 nm was covered with a molded object containing the first and second fluorescent bodies in combination. The peak of the light emitted from the first fluorescent body was set at wavelength of 650 nm and the peak of the light emitted from the second fluorescent body was set at wavelength of 520 nm.

In the comparative example, as depicted in Fig. 9, the yellow light component in a range from about 560 nm to 600 nm in peak wavelength was greater in relative intensity than the green light having the peak at wavelength of 520 nm. This was because the fluorescent bodies for the emission of red light and green light were arranged in combination within the molded object, as a result of which a part of the green light was re-absorbed by the fluorescent body for the emission of red light and the yellow light component was increased relatively. When meat was irradiated with such irradiation light, the metric chroma value was equal to 43 which was lower than the metric chroma values obtained in Examples 1 through 3.

As can be seen from the afore-mentioned evaluation, the metric chroma values obtained in Examples 1 through 3 were greater than the metric chroma value obtained in the comparative example in which the fluorescent bodies for the emission of red light and green light were arranged in combination. This relatively reduced the yellow light component, thereby highlighting the red light. Accordingly, the chroma of meat grew higher and the meat looked vivid, which made it possible to desirably display an irradiation target.

The present invention is not limited to the configurations of the above-described embodiments but may be modified in many different forms without departing from the scope and spirit of the invention. For example, while the first and second fluorescent bodies are independently arranged in different LEDs in the respective embodiments described above, other configurations may be employed as far as the light emitted from the second fluorescent body is not re-absorbed by the first fluorescent body. While the above description is directed to a case of irradiating food (especially, meat) with the irradiation light, the present invention can be applied to not only food but also various kinds of displayed goods such as medical products.

While the invention has been shown and described with respect to the embodiments, it will be understood by those skilled in the art that various changes and modification may be made without departing from the scope of the invention as defined in the following claims.

## Claims

1. A light emitting device, comprising:
a first solid light-emitting element including a first light source for emitting blue light and a first fluorescent body excited by the blue light from the first light source to convert the blue light to light having a peak at wavelength between 630 nm and 680 nm; and
a second solid light-emitting element including a second light source for emitting blue light and a second fluorescent body excited by the blue light from the second light source to convert the blue light to light having a peak at wavelength between 500 nm and 550 nm.

2. The device of claim 1, wherein the first solid light-emitting element is arranged in a position relatively close to a central area.

3. The device of claim 1 or 2, wherein each of the first and the second light source is a light emitting diode for emitting the blue light.

4. The device of claim 1 or 2, wherein each of the first and the second light source is an organic light-emitting diode for emitting the blue light.

5. An illumination system, comprising:
a first light emitting device including a first solid light-emitting element having a first light source for emitting blue light and a first fluorescent body excited by the blue light from the first light source to convert the blue light to light having a peak at wavelength between 630 nm and 680 nm; and a second light emitting device including a second solid light-emitting element having a second light source for emitting blue light and a second fluorescent body excited by the blue light from the second light source to convert the blue light to light having a peak at wavelength between 500 nm and 550 nm.

6. A light irradiation method, comprising:
providing a first fluorescent body for converting blue light emitted from a first light source to light having a peak at wavelength between 630 nm and 680 nm;
providing a second fluorescent body for converting blue light emitted from a second light source to light having a peak at wavelength between 500 nm and 550 nm; and
converting the lights from the first and the second fluorescent body to light having a maximum peak at wavelength between 630 nm and 680 nm.
